**Europäisches Patentamt**

**European Patent Office**

**Office européen des brevets**

(19)

(11) Veröffentlichungsnummer : **0 546 305 B1**

(12)

# EUROPÄISCHE PATENTSCHRIFT

(45) Veröffentlichungstag der Patentschrift :
27.07.94 Patentblatt 94/30

(51) Int. Cl.⁵ : **H01J 37/20, H01J 37/28**

(21) Anmeldenummer : **92118559.1**

(22) Anmeldetag : **29.10.92**

(54) Vorrichtung zur korpuskularoptischen Untersuchung und/oder Bearbeitung von Materialproben.

(30) Priorität : **10.12.91 DE 4140710**

(43) Veröffentlichungstag der Anmeldung :
**16.06.93 Patentblatt 93/24**

(45) Bekanntmachung des Hinweises auf die
Patenterteilung :
**27.07.94 Patentblatt 94/30**

(84) Benannte Vertragsstaaten :
**DE GB NL**

(56) Entgegenhaltungen :
**EP-A- 0 057 646**
**WO-A-89/07330**
**US-A- 4 460 827**

(73) Patentinhaber : **ICT Integrated Circuit Testing
Gesellschaft für Halbleiterprüftechnik mbH
Klausnerring 1a
D-85551 Kirchheim (DE)**

(72) Erfinder : **Feuerbaum, Hans-Peter, Dr.
Dipl.-Phys.
Arno-Assmann-Strasse 14
W-8000 München 83 (DE)**

(74) Vertreter : **Tetzner, Volkmar, Dr.-Ing. Dr. jur.
Van-Gogh-Strasse 3
D-81479 München (DE)**

EP 0 546 305 B1

## Beschreibung

Die Erfindung betrifft eine Vorrichtung zur korpuskularoptischen Untersuchung und/oder Bearbeitung von Materialproben entsprechend dem Oberbegriff des Anspruches 1.

In der Halbleiterindustrie werden Wafer und sonstige Materialproben mit Hilfe von Rasterelektronenmikroskopen, Ionenstrahlsonden und Ionenstrahlreparaturgeräten unter verschiedenen Blickwinkeln untersucht und bearbeitet. Benötigt werden dazu Tischsysteme, die die Materialprobe in fünf Achsen (drei Achsen zur Longitudinalverschiebung sowie zwei Rotationsachsen) auf wenige µm genau positionieren können. Mit zunehmender Größe der Materialproben werden die Tischsysteme und die zugehörigen Vakuum-Kammern immer aufwendiger, um beispielsweise Materialverbiegungen zu kompensieren. Die herkömmlichen Tisch- und Kammersysteme verteuern sich daher mit zunehmender Größe der Materialproben überproportional.

Aus der US-A-4,460,827 ist ein Elektronenstrahlmikroskop entsprechend dem Oberbegriff des Anspruches 1 bekannt. Bei dieser Vorrichtung läßt sich die optische Saule durch Drehung um eine Rotationsachse kippen.

Der Erfindung liegt die Aufgabe zugrunde, eine Vorrichtung gemäß dem Oberbegriff des Anspruches 1 zu schaffen, die sich - unter Beibehaltung der erforderlichen Positioniermöglichkeiten - durch einen wesentlich einfacheren Aufbau auszeichnet.

Diese Aufgabe wird erfindungsgemäß durch die kennzeichnenden Merkmale des Anspruches 1 gelöst.

Während bei bekannten Ausführungen alle Positioniermöglichkeiten (in drei Longitudinalachsen und zwei Rotationsachsen) durch das entsprechend aufgebaute Tischsystem gegeben sind, wird erfindungsgemäß das Positionierungssystem geteilt. Bei einer bevorzugten Variante wird die x-, y- und z-Verschiebung durch das Tischsystem, die Kippung und Rotation durch die korpuskularoptische Säule realisiert.

Auf diese Weise ergibt sich ein wesentlich einfacher aufgebautes Tischsystem, dessen erforderliche Stabilität mit einem erheblich geringeren baulichen Aufwand erreicht werden kann. Durch die erfindungsgemäße Teilung des Positionierungssystems kann ferner insbesondere die Vakuum-Kammer für das Tischsystem wesentlich kleiner gehalten werden.

Vorteilhaft ist ferner, daß sich ein erfindungsgemäßes Gerät durch Austausch des verhältnismäßig einfachen Tischsystemes sehr gut an die jeweilige Aufgabenstellung anpassen läßt.

Zweckmäßige Ausgestaltungen der Erfindung sind Gegenstand der Unteransprüche und werden im Zusammenhang mit der folgenden Beschreibung eines Ausführungsbeispieles näher erläutert.

In der Zeichnung zeigen:

Fig.1    eine Schema-Darstellung eines Ausführungsbeispieles der erfindungsgemäßen Vorrichtung,

Fig.2 bis 8    Prinzip-Darstellungen zur Erläuterung der mathematischen Zusammenhänge.

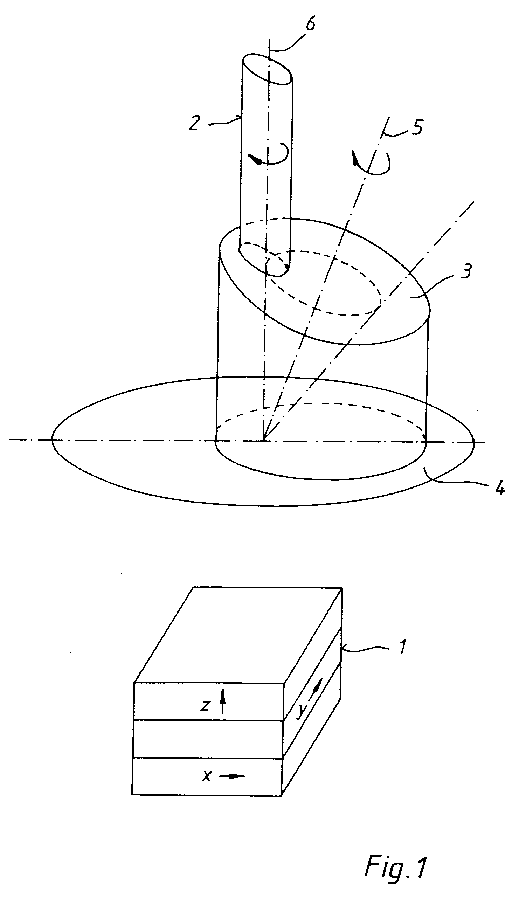

Das in Fig.1 ganz schematisch dargestellte erfindungsgemäße Rasterelektronenmikroskop enthält ein die zu untersuchende Materialprobe (Wafer) aufnehmendes Tischsystem 1, das eine Verschiebung der Materialprobe in drei senkrecht zueinander stehenden Koordinatenachsen (x, y, z) gestattet.

Eine elektronenmikroskopische Säule 2 ist unter einem bestimmten Winkel geneigt auf einer Grundplatte 3 angeordnet, die ihrerseits um denselben Winkel gegenüber einer Rotationsscheibe 4 geneigt ist. Die Grundplatte 3 mit der Säule 2 ist um eine erste Rotationsachse 5 drehbar. Weiterhin ist die Grundplatte 3 mit der Säule 2 durch die Rotationsscheibe 4 um die zweite Rotationsachse 6 drehbar.

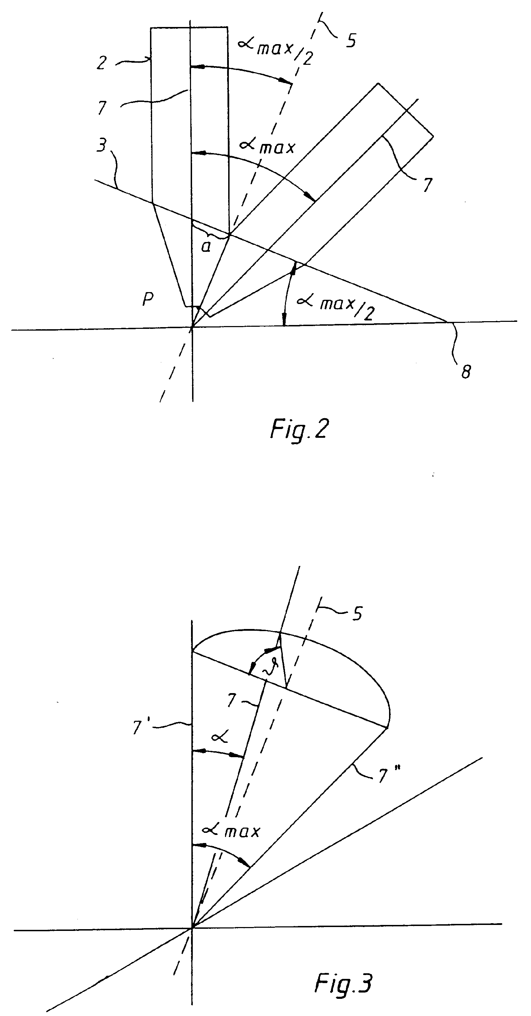

Durch Drehung der Grundplatte 3 um die erste Rotationsachse 5 wird der Winkel verändert, unter dem die elektronenmikroskopische Säule 2 die Materialprobe betrachtet. Die Drehung der Rotationsscheibe 4 ermöglicht ferner eine Verdrehung der gekippten Säule 2 gegenüber der Materialprobe, wie dies anhand der Fig.2 bis 8 noch im einzelnen erläutert wird.

Anhand der Fig.2 bis 5 seien zunächst die mathematischen Zusammenhänge für die Kippung der Säule 2 dargestellt. Es sei angenommen, daß die Säule 2 um einen Kippwinkel $\alpha$ gegenüber der Vertikalen gekippt werden soll, wobei der maximale Kippwinkel mit $\alpha_{max}$ bezeichnet sei. Die Säule 2 wird zu diesem Zweck auf der Grundplatte 3 so aufgebaut, daß ihre optische Achse 7 mit der ersten Rotationsachse 5 einen Neigungswinkel $\alpha_{max}/2$ einschließt. Die Säule 2 ist ferner so angeordnet, daß ihre optische Achse durch die zu untersuchende bzw. zu bearbeitende Stelle der Materialprobe (Punkt P in der x-, y-Objektebene 8) verläuft. Die Grundplatte 3 ist unter dem gleichen Winkel $\alpha_{max}/2$ geneigt schräg zur x-, y-Objektebene 8 angeordnet.

Damit sind die Säule 2 und das (in Fig.2 nicht veranschaulichte) Tischsystem relativ zueinander um die erste Rotationsachse 5 drehbeweglich. Diese erste Rotationsachse 5 schließt mit einer Senkrechten zu der von den x-, y-Koordinatenachsen gebildeten Ebene (x-, y-Objektebene 8) den Neigungswinkel $\alpha_{max}/2$ ein. Wird die Grundplatte 3 um die erste Rotationsachse 5 gedreht, so vollführt die Säule 2 eine Taumelbewegung. Ihre optische Achse 7 beschreibt hierbei einen Kegelmantel. Die Lage der Kegelspitze kann durch Wahl des Abstands a auf der ersten Rotationsachse 5 verschoben werden. Die Lage der Kegelspitze definiert den euzentrischen Arbeitspunkt und damit den Arbeitsabstand des Gerätes. Die x-, y-Objektebene 8 muß durch die Kegelspitze gehen.

Anhand der Fig.3 bis 5 sei nun der Zusammenhang zwischen dem Kippwinkel $\alpha$ der optischen Achse und dem Drehwinkel $\delta$ um die erste Rotationsachse erläutert.

Fig.3 zeigt die Ausgangslage 7', die Endlage 7″ und eine Zwischenlage 7 der optischen Achse bei ihrer Kippbewegung um die erste Rotationsachse 5. In der Zwischenlage 7 ist der Kippwinkel mit $\alpha$ und der Drehwinkel mit $\delta$ bezeichnet.

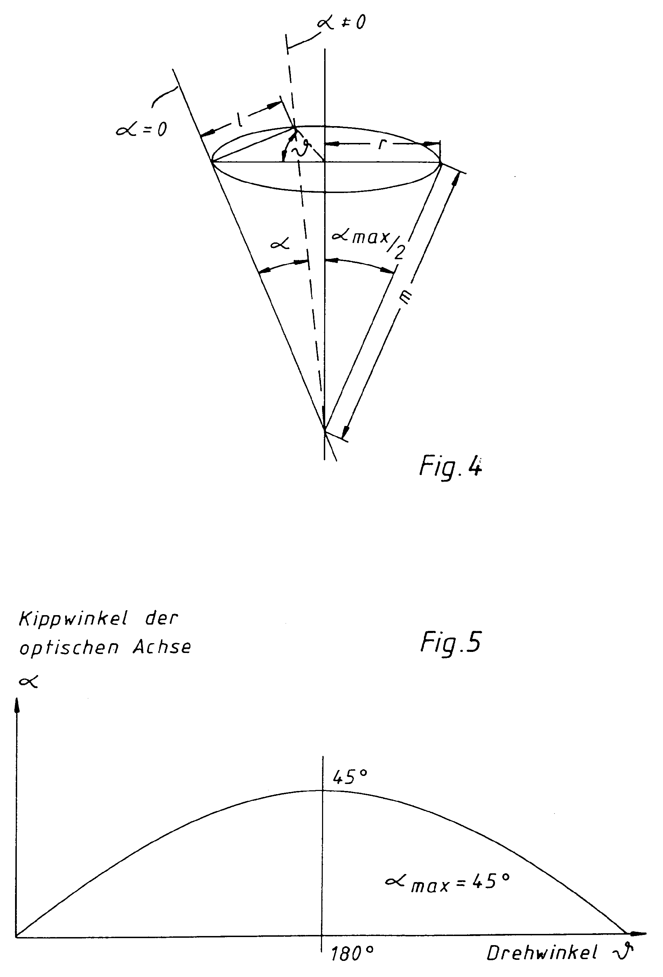

Bei der Ermittlung der Funktion $\alpha(\delta)$ stellt man den Kippwinkel zweckmäßig senkrecht auf die Spitze (Fig.4) und betrachtet die Basis des Kegels von oben. Dann ergeben sich unter Benutzung der aus Fig.4 ersichtlichen Formelzeichen folgende Zusammenhänge:

$$\sin \alpha_{max}/2 \; = \; r/m \quad (1)$$

$$l^2 \; = \; 2m^2 \, (1 \, - \, \cos\alpha) \quad (2)$$

$$l^2 \; = \; 2r^2 \, (1 \, - \, \cos\delta) \quad (3)$$

Aus (1), (2) und (3) folgt

$$\alpha \; = \; 2 \arcsin \, (\sin\alpha_{max}/2 \, * \, \sin\delta/2) \quad (4).$$

Fig.5 zeigt den Verlauf dieser Funktion, der prinzipiell auch anschaulich klar wird: Für kleine Drehwinkel $\delta$ entfernt sich die optische Achse quasi radial aus der Ausgangslage. Nähert sich $\delta$ dagegen 180°, strebt also die Achse der maximalen Kippung zu, so ist die Bewegung tangential; der Kippwinkel ändert sich nicht nennenswert, die Funktion verläuft daher annähernd horizontal.

Die vorstehend erläuterte Taumelbewegung der Säule 2 um die erste Rotationsachse 5 läßt sich nun durch die zusätzliche Rotation der Säule 2 um die zweite Rotationsachse 6 kompensieren.

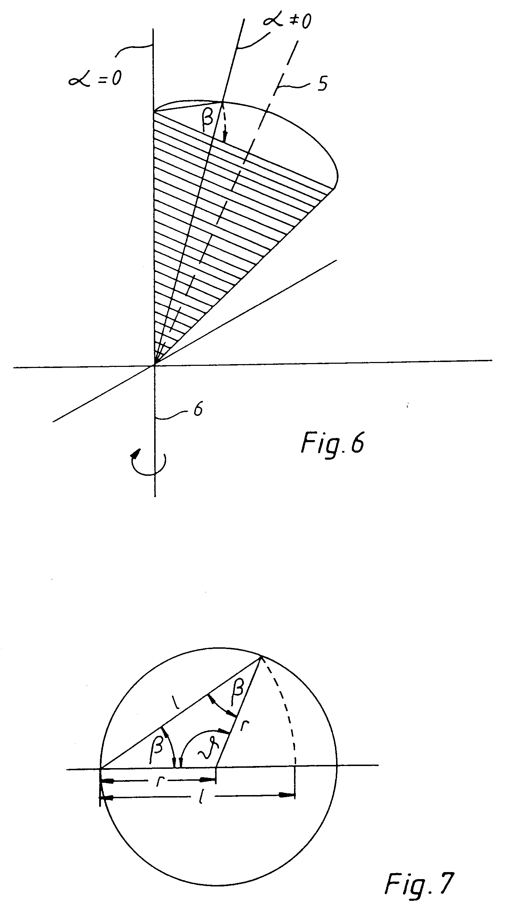

Die Fig.6 und 7 veranschaulichen dies in schematischer Form.

Das Ziel der Maßnahme ist es, die optische Achse 7 der Säule auch bei einer Kippbewegung (Drehung um die erste Rotationsachse 5) immer in der schraffiert gezeichneten Ebene (d.h. in einer senkrecht auf den x-y-Koordinatenachse stehenden Ebene) zu halten. Zu diesem Zweck muß die gesamte Anordnung um die Ausgangslage der optischen Achse rotiert werden, d.h. um die in Fig.1 dargestellte zweite Rotationsachse 6, die mit der optischen Achse 7 der Säule in der Ausgangslage ($\alpha = 0$) zusammenfällt.

Fig.7 zeigt, wie gedreht werden muß:

$$2\beta \; = \; 180° \, - \, \delta \quad (5)$$

Daraus folgt

$$\beta \; = \; 90° \, - \, \delta/2 \quad (6).$$

Zum Ausgleich der Taumelbewegung wird daher erfindungsgemäß eine Steuereinrichtung vorgesehen, durch die die Relativdrehung zwischen der Säule und dem Tischsystem um die erste Rotationsachse 5 (Drehwinkel $\delta$ ) und die Relativdrehung zwischen der Säule und dem Tischsystem um die zweite Rotationsachse 6 (Drehwinkel $\beta$) gemäß der Beziehung $\beta = 90° - \delta/2$ derart erfolgen, daß sich die optische Achse der Säule bei einer Änderung des zwischen der optischen Achse der Säule und der zweiten Rotationsachse 6 gebildeten Winkels $\alpha$ in einer senkrecht auf den x-y-Koordinatenachse stehenden Ebene bewegt.

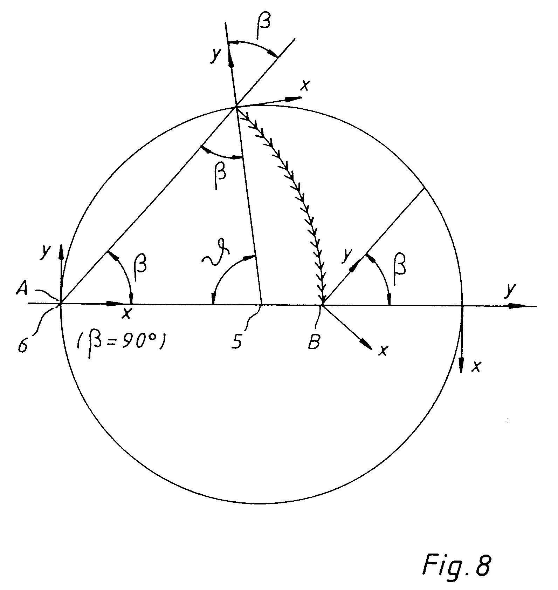

Zweckmäßig ist weiterhin ein Ausgleich der Rasterrotation, was anhand der Fig.8 erläutert sei.

Die elektronenmikroskopische Säule dreht sich bei ihrer Kippbewegung (d.h. bei der Drehung um die erste Rotationsachse 5) zugleich um die eigene Achse. Da die Einrichtung zur Ablenkung des Korpuskularstrahles längs zweier senkrecht zueinander stehender Koordinatenachsen (das sog. Scan-System) fest zur optischen Achse orientiert ist, dreht es sich mit, so daß das Bild auf dem Monitor rotiert. Dies wird zweckmäßig durch eine gegenläufige Scan-Rotation kompensiert.

Fig.8 zeigt, wie sich das Scan-System verlagert, wenn die Säule um den Winkel $\pi$ - bezogen auf die erste Rotationsachse 5 - und zum Zwecke des Taumelausgleiches um den Winkel $\beta$ - bezogen auf die zweite Rotationsachse 6 - aus der Anfangsposition A in die Endposition B gedreht wird.

Eine Betrachtung zeigt, daß die y-Achse des Scan-Systems mit der Kipprichtung immer den Winkel $\beta = 90 - \delta/2$ einschließt. Wenn also die Ausrichtung des Scan-Systemes konstant bleiben soll, muß das Scan-System bei einer Relativdrehung zwischen der Säule und dem Tischsystem um die zweite Rotationsachse 6 (Drehwinkel $\beta$) gegenläufig zu dieser Drehung um den Winkel 90° - $\beta$ zurückgedreht werden.

Bei der vorstehenden Beschreibung eines Ausführungsbeispieles wurde angenommen, daß das Tischsystem längs dreier senkrecht zueinander stehender Koordinatenachsen x, y und z verschiebbar ist, während die Säule um zwei Rotationsachsen 5, 6 drehbar ist.

Im Rahmen der Erfindung ist es jedoch auch möglich, die Relativbewegungen anders vorzusehen. So

3

EP 0 546 305 B1

kann beispielsweise die Säule nur um eine Rotationsachse und das Tischsystem um die andere Rotationsachse drehbar sein. Denkbar ist weiterhin, die Rotationsbewegung um beide Rotationsachsen dem Tischsystem zuzuweisen. Schließlich ist es im Rahmen der Erfindung auch möglich, die Longitudinalverschiebung in z-Richtung durch die Säule auszuführen.

## Patentansprüche

1. Vorrichtung zur korpuskularoptischen Untersuchung und/oder Bearbeitung von Materialproben, enthaltend

   a) eine korpuskularoptische Säule zur Erzeugung eines Korpuskularstrahles

   b) sowie ein die Materialprobe aufnehmendes, in einer durch zwei senkrecht zueinander stehende Koordinatenachsen (x, y) gebildeten Ebene angeordnetes Tischsystem, wobei

   c) die Säule und das Tischsystem relativ zueinander um eine erste Rotationsachse drehbeweglich sind, die mit einer Senkrechten zu der von den x-,y-Koordinatenachsen gebildeten Ebene einen Neigungs-winkel ($\alpha_{max}$/2) von maximal 45° einschließt und durch die zu untersuchende bzw. zu bearbeitende Stelle der Materialprobe verläuft

   d) und wobei die Säule ferner derart angeordnet ist, daß ihre optische Achse mit der ersten Rotationsachse den vorstehend genannten Neigungswinkel ($\alpha_{max}$/2) bildet und durch die zu untersuchende bzw. zu bearbeitende Stelle der Materialprobe verläuft,

   dadurch gekennzeichnet, daß

   e) die Materialprobe durch das Tischsystem wenigstens in den beiden Koordinatenachsen (x, y) verschiebbar ist,

   f) und daß die Säule und das Tischsystem relativ zueinander zusätzlich um eine zweite Rotationsachse drehbeweglich sind, die senkrecht zu der von den x-,y-Koordinatenachsen gebildeten Ebene steht und durch die zu untersuchende bzw. zu bearbeitende Stelle der Materialprobe verläuft.

2. Vorrichtung nach Anspruch 1, dadurch gekennzeichnet, daß die Säule und das Tischsystem auch in einer senkrecht zu den x-,y-Koordinatenachsen stehenden z-Koordinatenachse relativ zueinander verschiebbar sind.

3. Vorrichtung nach Anspruch 1, gekennzeichnet durch eine Steuereinrichtung, durch die die Relativdrehung zwischen der Säule und dem Tischsystem um die erste Rotationsachse (Drehwinkel $\delta$) und die Re-lativdrehung zwischen der Säule und dem Tischsystem um die zweite Rotationsachse (Drehwinkel $\beta$) ge-mäß der Beziehung

$$\beta = 90° - \delta/2$$

derart erfolgen, daß sich die optische Achse der Säule bei einer Änderung des zwischen der optischen Achse der Säule und der zweiten Rotationsachse gebildeten Kippwinkels ($\alpha$) in einer senkrecht auf den x-, y-Koordinatenachsen stehenden Ebene bewegt.

4. Vorrichtung nach Anspruch 3 mit einer Einrichtung zur Ablenkung des Korpuskularstrahles längs zweier senkrecht zueinander stehender Koordinatenachsen (x, y), gekennzeichnet durch eine Steuereinrichtung, durch die die Koordinatenachsen (x, y) der Strahlablenkung bei einer Relativdrehung zwischen der Säule und dem Tischsystem um die zweite Rotationsachse (Drehwinkel $\beta$) gegenläufig zu dieser Drehung um den Winkel 90° - $\beta$ zurückgedreht werden.

## Claims

1. Device for corpuscular-optical examination and/or processing of material specimens, comprising

   a) a corpuscular-optical column for producing a corpuscular beam,

   b) as well as a table system which receives the material specimen and which is disposed in a plane formed by two axes (x, y) which are at right angles to each other, wherein

   c) the column and the table system are rotatable relative to one another about a first axis of rotation which with a perpendicular to the plane formed by the x and y axes encloses an angle of inclination ($\alpha_{max}$ /2) of a maximum of 45° and passes through the place to be examined or to be processed on the material specimen;

   d) and wherein the column is also arranged in such a way that its optical axis forms the aforementioned

4

angle of inclination ($\alpha_{max}$/2) with the first axis of rotation and passes through the place to be examined or to be processed on the material specimen,
characterised in that

   e) the material specimen is movable through the table system at least in the two axes (x, y),

   f) and that the column and the table system are additionally rotatable relative to one another about a second axis of rotation which is perpendicular to the plane formed by the x, y axes and passes through the place on the material specimen to be examined or to be processed.

2. Device as claimed in claim 1, characterised in that the column and the table system are also movable relative to one another in a z axis which is perpendicular to the x, y axes.

3. Device as claimed in claim 1, characterised by a control arrangement by means of which the relative rotation between the column and the table system about the first axis of rotation (angle of rotation $\delta$) and the relative rotation between the column and the table system about the second axis of rotation (angle of rotation $\beta$) take place in accordance with the equation

$$\beta = 90° - \delta/2$$

in such a way that the optical axis of the column moves in a plane standing perpendicular on the x, y axes in the event of an alteration in the angle of tilt ($\alpha$) formed between the optical axis of the column and the second axis of rotation.

4. Device as claimed in claim 3 with an arrangement for deflecting the corpuscular beam along two axes (x, y) standing at right angles to one another, characterised by a control arrangement by means of which, in the event of a relative rotation between the column and the table system about the second axis of rotation (angle of rotation $\beta$), the axes (x, y) of the beam deflection are rotated back by the angle 90° - $\beta$ counter to this rotation.

**Revendications**

1. Dispositif d'analyse et/ou de traitement d'échantillons de matière par voie opto-corpusculaire, comprenant

   a) une colonne opto-corpusculaire de génération d'un faisceau de corpuscules

   b) ainsi qu'un système de table supportant l'échantillon de matière et disposé dans un plan formé par deux axes de coordonnées (x, y) perpendiculaires l'un à l'autre,

   c) la colonne et le système de table étant mobiles en rotation l'une par rapport à l'autre autour d'un premier axe qui inscrit avec une perpendiculaire au plan formé par les axes de coordonnées (x, y) un angle d'inclinaison ($\alpha_{max}$/2) qui est au maximum de 45 et qui passe par le lieu de l'échantillon de matière auquel l'analyse ou le traitement doit être effectué

   d) et la colonne étant par ailleurs disposée de manière que son axe optique forme avec le premier axe de rotation ledit angle d'inclinaison ($\alpha_{max}$/2) et passe par le lieu de l'échantillon de matière auquel l'analyse ou le traitement doit être effectué,
   caractérisé en ce que

   e) l'échantillon de matière est déplaçable par le système de table au moins suivant les deux axes de coordonnées (x, y),

   f) et en ce que la colonne et le système de table sont accessoirement mobiles en rotation l'une par rapport à l'autre autour d'un second axe de rotation qui est perpendiculaire au plan formé par les axes de coordonnées x,y et qui passe par le lieu auquel l'analyse ou le traitement de l'échantillon de matière doit être effectué.

2. Dispositif selon la revendication 1, caractérisé en ce que la colonne et le système de table sont aussi déplaçables l'une par rapport à l'autre sur un axe de coordonnée z qui est perpendiculaire aux axes de coordonnées x, y.

3. Dispositif selon la revendication 1, caractérisé par un dispositif de commande qui provoque la rotation relative entre la colonne et le système de table autour du premier axe de rotation (angle de rotation $\delta$) ainsi que la rotation relative entre la colonne et le système de table autour du second axe (angle de rotation $\beta$) suivant la relation

$$\beta = 90° - \delta/2$$

de manière que l'axe optique de la colonne se déplace dans un plan perpendiculaire aux axes de coordonnées x, y lors d'une variation de l'angle d'inclinaison ($\alpha$) formé entre l'axe optique de la colonne et le second axe de rotation.

4. Dispositif selon la revendication 3, comprenant un dispositif de déviation du faisceau de corpuscules le long de deux axes de coordonnées (x, y) qui sont perpendiculaires l'un à l'autre, caractérisé par un dispositif de commande qui, lors d'une rotation relative entre la colonne et le système de table autour du second axe de rotation (angle de rotation $\beta$), fait tourner vers l'arrière en sens inverse à cette rotation les axes de coordonnées (x, y) de la déviation du faisceau de l'angle 90° - $\beta$.

*Fig.1*

Fig.2

Fig.3

8

Fig. 4

Kippwinkel der
optischen Achse

Fig. 5

Fig.6

Fig.7

Fig. 8